# EUROPEAN PATENT APPLICATION

(11) **EP 1 533 352 A1**
(43) Date of publication of application: **25.05.2005**
(21) Application number: 04256808.9
(22) Date of filing: 04.11.2004
(51) Int. Cl.: C09G 1/02

(54) **Compositions and methods for polishing copper**

(30) Priority: 13.11.2003 US 712446
(71) Applicant: Rohm and Haas Electronic Materials CMP Holdings, Inc., Wilmington, DE 19899 (US)
(72) Inventor: Thomas, Terence M., Newark DE 19711 (US); So, Joseph K., Newark DE 19711 (US)
(74) Representative: Buckley, Guy Julian

(57) **Abstract**

The present invention provides an aqueous composition useful for polishing copper on a semiconductor wafer comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.0001 to 2 salt having a cationic and an anionic component, and balance water, the salt reducing noise level from vibration between the wafer and a polishing pad.

## Description

### BACKGROUND OF THE INVENTION

The invention relates to chemical mechanical planarization (CMP) of semiconductor wafer materials and, more particularly, to CMP compositions and methods for polishing copper interconnects from semiconductor wafers in the presence of dielectrics and barrier materials.

Typically, a semiconductor wafer has a wafer of silicon and a dielectric layer containing multiple trenches arranged to form a pattern for circuit interconnects within the dielectric layer. The pattern arrangements usually have a damascene structure or dual damascene structure. A barrier layer covers the patterned dielectric layer and a metal layer covers the barrier layer. The metal layer has at least sufficient thickness to fill the patterned trenches with metal to form circuit interconnects.

CMP processes often include multiple polishing steps. For example, a first step removes a metal layer from underlying barrier dielectric layers. The first step polishing removes the metal layer, while leaving a smooth planar surface on the wafer with metal-filled trenches that provide circuit interconnects planar to the polished surface. First step polishing removes excess interconnect metals, such as copper at an initial high rate. After the first step removal, the second step polishing can remove a barrier that remains on the semiconductor wafer. This second step polishing removes the barrier from an underlying dielectric layer of a semiconductor wafer to provide a planar polished surface on the dielectric layer.

Unfortunately, high friction in the polishing zone involving polyurethane polishing pads and the semiconductor wafers, containing metal interconnects thereon, can result in vibration from the polishing zone. This vibration results in a loud stick-slip event that continues throughout the first step polish cycle, making it difficult for technicians to work around. In addition, the problem can be so severe that the wafer carriers are damaged, and debris from the carrier may contaminate the polishing zone, causing unwanted scratching on the wafer surface.

Tsuchiya et al. (U.S. Patent No. 6,585,568), discloses a slurry for polishing copper that reduces vibration by mixing, at a ratio of 5 to 70, triazole compounds with benzotriazole compounds, respectively. However, the addition of benzotriazole leads to a decrease in the polishing rate of the copper, and excessive amounts of the benzotriazole increases vibration noise. In addition, some manufacturers have modified their polishing parameters, such as reducing applied pressure. However, these modifications generally result in reduced removal rate and productivity.

Hence, what is needed is an improved polishing composition and method for effectively polishing copper interconnects with reduced noise levels. In particular, there is a need for a composition and method for reducing noise levels during polishing of copper interconnects, that does not detrimentally effect the polishing rate.

### STATEMENT OF THE INVENTION

In a first aspect, the present invention provides an aqueous composition useful for polishing copper on a semiconductor wafer comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.0001 to 2 salt having a cationic and an anionic component, and balance water, the salt reducing noise level from vibration between the wafer and a polishing pad.

In a second aspect, the present invention provides a method for polishing copper from a semiconductor wafer comprising, contacting the wafer with a polishing composition, the wafer containing the copper, the polishing composition comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.0001 to 2 salt, and balance water, and polishing the wafer with a polishing pad, the salt reducing noise level from vibration between the wafer and the polishing pad.

### DETAILED DESCRIPTION

The composition and method provide unexpected reduction in noise levels from vibration caused during polishing of copper interconnects. The composition of the present invention utilizes the addition of salts, or mixtures thereof, to effectively reduced noise levels from vibration during first step polishing of copper interconnects on the wafer. Further, the addition of salts advantageously reduces the residual polishing time of the wafer. Although the present invention has particular usefulness in copper interconnects, the present aqueous polishing composition also provides enhanced polishing of other metal interconnects, such as aluminum, nickel, iron, steel, beryllium, zinc, titanium, chromium and the like.

For purposes of this specification, "salt" is defined as a compound produced from the reaction of an acid and a base, or a metal and an acid either in a separate prior reaction or in situ in the ultimate mixture in which the salt is to be used. Thus, the salt includes a cationic component and an anionic component. The cationic component may be substantially any of the ionized elements that will not deposit by electroless plating on the metal surface being polished. A preferred cationic component of the salt is an ionized element from Groups IA, IIA, IIIA, IVA and IVB of the periodic table of elements (IUPAC convention), as well as zinc, cerium, iron (2⁺ or 3⁺), ammonium, and guanidine ions. Generally, heavy metals of the indicated groups are not favored due to cost and pollution factors. The zirconyl cation, ZrO²⁺, is among the preferred cations. The anionic component of the salt preferably includes chloride, bromide, iodide, nitrate, phosphate, polyphosphate, sulfate, carbonate and perchlorate ions.

A preferred aqueous polishing composition can be formulated using at least one salt comprising aluminum chloride, zirconyl nitrate, zirconyl sulfate, cerium nitrate, aluminum nitrate, aluminum bromide, aluminum iodide, aluminum chloride, zirconyl chloride, tin chloride, aluminum perchlorate, magnesium chloride, zinc chloride, magnesium perchlorate, iron chloride, potassium chloride, potassium sulfate, guanidine nitrate, guanidine sulfate, guanidine carbonate, ammonium chloride, ammonium nitrate, ammonium phosphate or the like.

Advantageously, the salt component of the polishing composition of the present invention is present in an amount effective to reduce noise levels in the polishing zone. The water component of the polishing composition is primarily a suspending agent for suspending the solid components and as a solvent for the salt component. If desired, the polishing composition can be prepared in a concentrated form and diluted for use by the addition of water to the desired concentration. It is believed that even a trace amount of salt present in the polishing composition is effective for polishing the copper. A satisfactory reduction in noise levels with acceptable polishing efficiency is obtained by using the salt in an amount of about 0.0001 to about 2 weight percent of the composition. A preferred range for the salt component is about 0.001 to about 1 weight percent of the composition. Most preferably, the salt component is about 0.01 weight percent of the composition.

Since the salt normally dissolves in the water used, the particle size of the salt is not critical. However, the salt particle size is desirably small enough so as to rapidly dissolve in water. In addition, many of these salts are preferably in hydrated form to prevent decomposition upon contact with water. The temperature at which the salt or combination of salts and water is mixed, the rate of addition of salt or combination of salts to the water, and the mixing parameters, such as the mixing rate of the salt or combination of salts and water to form the polishing composition, are generally as followed in the industry, and well known to those skilled in the art.

In addition, the polishing composition salt or salts may be generated in situ. The appropriate acid and base may be added to an aqueous composition, for example, Mg(OH)₂ may be combined with HNO₃ to form Mg(NO₃)₂ and water. Alternatively, the salt or salts may be generated in situ by the addition of the metal with an acid, for example, powdered zinc metal plus hydrochloric acid to form ZnCl₂.

Advantageously, the novel polishing composition contains about 0.01 to 5 weight percent of a carboxylic acid polymer. Preferably, the composition contains about 0.05 to 2 weight percent of a carboxylic acid polymer. Also, the polymer preferably has a number average molecular weight of about 20,000 to 1,500,000. In addition, blends of higher and lower number average molecular weight carboxylic acid polymers can be used. These carboxylic acid polymers generally are in solution but may be in an aqueous dispersion. The number average molecular weight of the aforementioned polymers are determined by GPC (gel permeation chromatography).

The carboxylic acid polymers are formed from unsaturated monocarboxylic acids and unsaturated dicarboxylic acids. Typical unsaturated monocarboxylic acid monomers contain 3 to 6 carbon atoms and include acrylic acid, oligomeric acrylic acid, methacrylic acid, crotonic acid and vinyl acetic acid. Typical unsaturated dicarboxylic acids contain 4 to 8 carbon atoms and include the anhydrides thereof and are, for example, maleic acid, maleic anhydride, fumaric acid, glutaric acid, itaconic acid, itaconic anhydride, and cyclohexene dicarboxylic acid. In addition, water soluble salts of the aforementioned acids also can be used.

Particularly useful are "poly(meth)acrylic acids" having a number average molecular weight of about 20,000 to 150,000, preferably 25,000 to 75,000 and more preferably, 25,000 to 40,000. As used herein, the term "poly(meth)acrylic acid" is defined as polymers of acrylic acid or polymers of methacrylic acid. Blends of varying number average molecular weight poly(meth)acrylic acids are particularly preferred. In these blends or mixtures of poly(meth)acrylic acids, a lower number average molecular weight poly(meth)acrylic acid having a number average molecular weight of 20,000 to 100,000 and preferably, 20,000 to 40,000 is used in combination with a higher number average molecular weight poly(meth)acrylic acid having a number average molecular weight of 150,000 to 1,500,000, preferably, 200,000 to 300,000. Typically, the weight percent ratio of the lower number average molecular weight poly(meth)acrylic acid to the higher number average molecular weight poly(meth)acrylic acid is about 10:1 1 to 1:10, preferably 4:1 to 1:4, and more preferably, 2:1 to 1:2. A preferred blend comprises a polyacrylic acid having a number average molecular weight of about 30,000 and a polyacrylic acid having a number average molecular weight of about 250,000 in a 1:1 weight ratio.

In addition, carboxylic acid containing copolymers and terpolymers can be used in which the carboxylic acid component comprises 5-75% by weight of the polymer. Typical of such polymer are polymers of (meth)acrylic acid and acrylamide or methacrylamide; polymers of (meth)acrylic acid and styrene and other vinyl aromatic monomers; polymers of alkyl (meth)acrylates (esters of acrylic or methacrylic acid) and a mono or dicarboxylic acid, such as, acrylic or methacrylic acid or itaconic acid; polymers of substituted vinyl aromatic monomers having substituents, such as, halogen, i.e., chlorine, fluorine, bromine, nitro, cyano, alkoxy, haloalkyl, carboxy, amino, amino alkyl and a unsaturated mono or dicarboxylic acid and an alkyl (meth)acrylate; polymers of monethylenically unsaturated monomers containing a nitrogen ring, such as, vinyl pyridine, alkyl vinyl pyridine, vinyl butyrolactam, vinyl caprolactam, and an unsaturated mono or dicarboxylic acid; polymers of olefins, such as, propylene, isobutylene, or long chain alkyl olefins having 10 to 20 carbon atoms and an unsaturated mono or dicarboxylic acid; polymers of vinyl alcohol esters, such as, vinyl acetate and vinyl stearate or vinyl halides, such as, vinyl fluoride, vinyl chloride, vinylidene fluoride or vinyl nitriles, such as, acrylonitrile and methacrylonitrile and an unsaturated mono or dicarboxylic acid; polymers of alkyl (meth) acrylates having 1-24 carbon atoms in the alkyl group and an unsaturated monocarboxylic acid, such as, acrylic acid or methacrylic acid. These are only a few examples of the variety of polymers that can be used in the novel polishing composition of this invention. Also, it is possible to use polymers that are biodegradeable, photodegradeable or degradeable by other means. An example of such a composition that is biodegradeable is a polyacrylic acid polymer containing segments of poly(acrylate comethyl 2-cyanoacrylate).

Advantageously, the solution contains 1 to 15 weight percent oxidizer. More preferably, the oxidizer is in the range of 5 to 10 weight percent. The oxidizer is particularly effective at assisting the solution in removing copper oxide films that can form at low pH ranges. The oxidizing agent can be at least one of a number of oxidizing compounds, such as hydrogen peroxide (H₂O₂), monopersulfates, iodates, magnesium perphthalate, peracetic acid and other per-acids, persulfates, bromates, periodates, nitrates, iron salts, cerium salts, Mn (III), Mn (IV) and Mn (VI) salts, silver salts, copper salts, chromium salts, cobalt salts, halogens hypochlorites and a mixture thereof. Furthermore, it is often advantageous to use a mixture of oxidizer compounds. When the polishing slurry contains an unstable oxidizing agent such as, hydrogen peroxide, it is often most advantageous to mix the oxidizer into the composition at the point of use.

Further, the solution contains 0.1 to 1.0 weight percent inhibitor to control copper interconnect removal rate by static etch or other removal mechanism. Adjusting the concentration of an inhibitor adjusts the interconnect metal removal rate by protecting the metal from static etch. Advantageously, the solution contains 0.2 to 0.50 weight percent inhibitor. The inhibitor may consist of a mixture of inhibitors. Azole inhibitors are particularly effective for copper and silver interconnects. Typical azole inhibitors include benzotriazole (BTA), mercaptobenzothiazole (MBT), tolytriazole and imidazole. BTA is a particularly effective inhibitor for copper and silver.

In addition to the inhibitor, the composition advantageously contains 0.05 to 3 weight percent complexing agent for the nonferrous metal. The complexing agent, prevents precipitation of the metal ions formed by dissolving the nonferrous metal interconnects. Advantageously, the composition contains 0.1 to 1 weight percent complexing agent for the nonferrous metal. Example complexing agents include acetic acid, citric acid, ethyl acetoacetate, glycolic acid, lactic acid, malic acid, oxalic acid, salicylic acid, sodium diethyl dithiocarbamate, succinic acid, tartaric acid, thioglycolic acid, glycine, alanine, aspartic acid, ethylene diamine, trimethyl diamine, malonic acid, gluteric acid, 3-hydroxybutyric acid, propionic acid, phthalic acid, isophthalic acid, 3-hydroxy salicylic acid, 3,5-dihydroxy salicylic acid, gallic acid, gluconic acid, pyrocatechol, pyrogallol, tannic acid, including, salts and mixtures thereof. Advantageously, the complexing agent is selected from the group consisting of acetic acid, citric acid, ethyl acetoacetate, glycolic acid, lactic acid, malic acid, oxalic acid and mixtures thereof. Most advantageously, the complexing agent is malic acid.

In addition, the polishing composition of this invention contains 0.01 to 5.0 weight percent of modified cellulose. Preferably, the composition contains 0.1 to 3 weight percent of modified cellulose. The addition of modified cellulose (for e.g. carboxymethyl cellulose) provides unexpected reduction of dishing values to the polishing composition. Exemplary modified cellulose are anionic gums such as agar gum, arabic gum, ghatti gum, karaya gum, guar gum, pectin, locust bean gum, tragacanth gums, tamarind gum, carrageenan gum, and xantham gum; modified starch; modified N-containing polymers that can bind through the donation of lone pair electrons; polymers that contain a phosphate group for binding to the surface; polymers that contain hydrophobic modified groups that can bind to the surface through a hydrophobicity; polymers that contains a hydrogen-bond forming group to bind to the surface, and their modifications and combinations.

The composition and method provide unexpected reduction in noise levels from vibration caused during polishing of copper interconnects. The abrasive-free polishing composition or fluid of the present invention utilizes the addition of salts, or mixtures thereof, to effectively reduced noise levels from vibration during first step polishing of copper interconnects on the wafer. Further, the addition of salts advantageously reduces the residual polishing time of the wafer. The aqueous composition comprises an oxidizer, inhibitor, complexing agent, polymers and salt, and balance water. In addition, the present composition provides a substantial reduction in dishing of the copper circuits of the wafer in comparison to conventional polishing compositions. The novel polishing composition provides a substantially planar surface that is free of scratches and other defects that commonly result from polishing.

The compounds provide efficacy over a broad pH range in solutions containing a balance of water. This solution's useful pH range extends from at least 2 to 5. In addition, the solution advantageously relies upon a balance of deionized water to limit incidental impurities. The pH of the polishing fluid of this invention is preferably from 2.8 to 4.2, more preferably a pH of 2.6 to 3.8. The acids used to adjust the pH of the composition of this invention are, for example, nitric acid, sulfuric acid, hydrochloric acid, phosphoric acid and the like. Exemplary bases used to adjust the pH of the composition of this invention are, for example, ammonium hydroxide and potassium hydroxide.

Further, the polishing composition may optionally contain 0 to 3 weight percent abrasive to facilitate metal layer removal. Within this range, it is desirable to have the abrasive present in an amount of greater than or equal to 0.01 weight percent. Also, desirable within this range is an amount of less than or equal to 1 weight percent.

The abrasive has an average particle size of less than or equal to 50 nanometers (nm) for preventing excessive metal dishing and dielectric erosion. For purposes of this specification, particle size refers to the average particle size of the abrasive. More preferably, it is desirable to use a colloidal abrasive having an average particle size of less than or equal to 40 nm. Further, minimal dielectric erosion and metal dishing advantageously occurs with colloidal silica having an average particle size of less than or equal to 30 nm. Decreasing the size of the colloidal abrasive to less than or equal to 30 nm, tends to improve the selectivity of the polishing composition, but, it also tends to decrease the removal rate. In addition, the preferred colloidal abrasive may include additives, such as dispersants, surfactants and buffers to improve the stability of the colloidal abrasive. One such colloidal abrasive is colloidal silica from Clariant S.A., of Puteaux, France. Also, other abrasives, including, those that are fumed, precipitated, agglomerated, etc., may be utilized.

The polishing composition may include the abrasive for "mechanical" removal of metal interconnect layers. Example abrasives include inorganic oxides, inorganic hydroxides, metal borides, metal carbides, metal nitrides, polymer particles and mixtures comprising at least one of the foregoing. Suitable inorganic oxides include, for example, silica (SiO₂), alumina (Al₂O₃), zirconia (ZrO₂), ceria (CeO₂), manganese oxide (MnO₂), or combinations comprising at least one of the foregoing oxides. Modified forms of these inorganic oxides, such as, polymer-coated inorganic oxide particles and inorganic coated particles may also be utilized if desired. Suitable metal carbides, boride and nitrides include, for example, silicon carbide, silicon nitride, silicon carbonitride (SiCN), boron carbide, tungsten carbide, zirconium carbide, aluminum boride, tantalum carbide, titanium carbide, or combinations comprising at least one of the foregoing metal carbides, boride and nitrides. Diamond may also be utilized as an abrasive if desired. Alternative abrasives also include polymeric particles and coated polymeric particles. The preferred abrasive, if utilized, is silica.

The composition of the present invention is applicable to any semiconductor wafer containing a conductive metal, such as copper, aluminum, tungsten, platinum, palladium, gold, or iridium; a barrier or liner film, such as tantalum, tantalum nitride, titanium, or titanium nitride; and an underlying dielectric layer. For purposes of the specification, the term dielectric refers to a semi-conducting material of dielectric constant, k, which includes low-k and ultra-low k dielectric materials. The composition and method are excellent for preventing erosion of multiple wafer constituents, for example, porous and nonporous low-k dielectrics, organic and inorganic low-k dielectrics, organic silicate glasses (OSG), fluorosilicate glass (FSG), carbon doped oxide (CDO), tetraethylorthosilicate (TEOS) and a silica derived from TEOS.

### Examples

In the Examples, numerals represent examples of the invention and letters represent comparative examples. All example solutions contained, by weight percent, 0.30 BTA, 0.22 malic acid, 0.15 carboxymethyl cellulose (CMC), a blend of 0.09 polyacrylic acid (30k)/ 0.09 polyacrylic acid (250k) and 9.00 hydrogen peroxide.

### Example 1

This experiment measured noise levels (dB) during polishing of residual copper from a semiconductor wafer. In particular, the test determined the effect of the addition of salt, or mixtures thereof, to the noise level during a first step (2^{nd} platen) polishing operation. An Applied Materials, Inc. Mirra 200mm polishing machine using an IC 1010™ polyurethane polishing pad (Rodel, Inc.) under downforce conditions of about 3 psi (20.7 kPa) and a polishing solution flow rate of 80 cc/min, a platen speed of 33 RPM and a carrier speed of 61 RPM planarized the samples. The polishing solutions had a pH of 3.4 adjusted with nitric acid. All solutions contained deionized water. The noise level was measured with an Extech Instruments, Inc. sound meter having a decibel range of 30-130 dB (+/- 1.5 dB). The background noise of the machine was measured at 75-77 dB. Unwanted noise was found at decibel levels, at or above, about 94 dB.

**Table 1**

| Second Platen Polishing Results for Noise Levels | | | |
|---|---|---|---|
| Test | Additive | Wt% | Noise level (dB) |
| A | None | -- | 95.0-99.0 |
| 1 | Potassium nitrate | 0.1 | 90.0-93.4 |
| 2 | Potassium nitrate/ Potassium chloride | 0.1/0.1 | 85.0-90.0 |
| 3 | Guanidine hydrochloride | 0.01 | 86.1-86.6 |
| 4 | Guanidine nitrate | 0.01 | 86.6-86.9 |
| 5 | Guanidine sulfate | 0.01 | 87.1-87.4 |
| 6 | Guanidine carbonate | 0.01 | 87.4-87.7 |

As illustrated in Table 1, the noise level was significantly reduced by the addition of salt, or mixtures thereof, to the control polishing fluid of the present invention. The addition of salt reduced the noise level from the vibration of the polishing pad contacting the wafer to at least below 94 dB. The addition of 0.1 to 0.01 weight percent of salt to the control polishing fluid provided reduced noise levels between 93.4 to 85 dB. In particular, the addition of 0.1 weight percent potassium nitrate (Test 1) to the control polishing fluid reduced the noise level to between 90-93.4 dB. In comparison, the polishing fluid without the addition of salt (Test A) produced unacceptable noise levels between 95-99 dB. Also, mixtures of 0.1 weight percent potassium nitrate and 0.1 weight percent potassium chloride (Test 2) reduced the noise level to 85-90 dB. The mixture of potassium salts provided the lowest noise level, at 85 dB. Further, various salts of guanidine (Tests 3-6) were added to the control polishing fluid, all at 0.01 weight percent, and these example polishing fluids provided reductions in noise levels from about 86.1 (guanidine hydrochloride) to about 87.7 dB (guanidine carbonate). Note, the noise levels discussed is at the test conditions for the Example as defined above. The noise levels may vary with changes made to the test parameters.

### Example 2

In this test, the polishing time for residual copper clearing was measured. The test samples were polished on second platen utilizing the same polishing conditions as Example 1, and the endpoint was measured utilizing an Applied Materials "Mirra" endpoint system. At T1, the underlying barrier layer (Ta or TaN) breaks through the copper layer and at T2, little or no residual copper is remaining. Test polishing fluids 1 and 2 contained 0.01 weight percent guanidine nitrate.

**Table 2**

| Second Platen Polishing Results for Residual Polish Time | | | |
|---|---|---|---|
| Test | T1 (sec) | T2 (sec) | T2-T1 (sec) |
| A | 118 | 175 | 57 |
| B | 113 | 175 | 62 |
| 1 | 115 | 150 | 35 |
| 2 | 97 | 131 | 34 |

As illustrated in Table 2, the addition of salt to the control polishing fluid reduced the polish time to remove the residual copper. In particular, the addition of 0.01 weight percent guanidine nitrate (Tests 1 and 2) reduced the polish time for removing the residual copper to 35 and 34 seconds, respectively. In comparison, the polishing fluids without the addition of salt (Tests A and B) needed 57 and 62 seconds, respectively, to remove the residual copper. In other words, the polish time is reduced by at least 38%.

The solution and method provide unexpected reduction in noise levels during polishing of copper interconnects. The polishing fluid of the present invention utilizes the addition of salts, or mixtures thereof, to effectively reduced noise levels from vibration during first step polishing of copper interconnects on the wafer to at least below 94 dB. Further, the addition of salts advantageously reduces the polishing time of the wafer by at least 38%. The aqueous composition comprises an oxidizer, inhibitor, complexing agent, polymers and salt, and balance water.

## Claims

1. An aqueous composition useful for polishing copper on a semiconductor wafer comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.0001 to 2 salt having a cationic and an anionic component, and balance water, the salt reducing noise level from vibration between the wafer and a polishing pad.

2. The composition of claim 1 wherein the cationic component comprises an ionized element selected from the group comprising Groups IA, IIA, IIIA, IVA and IVB of the periodic table of the elements, zinc, cerium, iron, ammonium and guanidine ions.

3. The composition of claim 1 wherein the anionic component is selected from the group comprising chloride, bromide, iodide, nitrate, phosphate, polyphosphate, sulfate, carbonate and perchlorate ions.

4. The composition of claim 1 wherein the salt is selected from the group comprising comprising aluminum chloride, zirconyl nitrate, zirconyl sulfate, cerium nitrate, aluminum nitrate, aluminum bromide, aluminum iodide, aluminum chloride, zirconyl chloride, tin chloride, aluminum perchlorate, magnesium chloride, zinc chloride, magnesium perchlorate, iron chloride, potassium chloride, potassium sulfate, guanidine hydrochloride, guanidine nitrate, guanidine sulfate, guanidine carbonate, ammonium chloride, ammonium nitrate and ammonium phosphate.

5. The composition of claim 1 wherein the carboxylic acid polymer comprises a blend of poly(meth)acrylic acid, the blend comprising a first polymer having a number average molecular weight of 20,000 to 100,000 and at least a second polymer having a number average molecular weight of 200,000 to 1,500,000.

6. The composition of claim 5 wherein the first polymer is a polyacrylic acid having a number average molecular weight of 30,000 and the second polymer is a polyacrylic acid having a number average molecular weight of 250,000, the first and second polymers present in a 1:1 weight ratio.

7. The composition of claim 1 wherein the modified cellulose is carboxymethyl cellulose.

8. The composition of claim 1 wherein the solution has a pH under 5.

9. A method for polishing copper from a semiconductor wafer comprising:
contacting the wafer with a polishing composition, the wafer containing the copper, the polishing composition comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.0001 to 2 salt, and balance water; and
polishing the wafer with a polishing pad, the salt reducing noise level from vibration between the wafer and the polishing pad.

10. The method of claim 9 wherein the salt reduces residual polishing time of the copper.
